# EUROPÄISCHE PATENTSCHRIFT

(11) **EP 2 882 617 B1**
(45) Veröffentlichungstag und Bekanntmachung des Hinweises auf die Patenterteilung: **29.11.2017**
(21) Anmeldenummer: 13750501.2
(22) Anmeldetag: 01.08.2013
(51) Int. Cl.: B60R 25/20

(54) **STEUERUNGSVERFAHREN UND STEUERUNGSSYSTEM FÜR EIN FAHRZEUGSCHLIESSELEMENT**
CONTROL METHOD AND CONTROL SYSTEM FOR A VEHICLE CLOSING ELEMENT
PROCÉDÉ ET SYSTÈME DE COMMANDE D'UN ÉLÉMENT DE FERMETURE DE VÉHICULE

(30) Priorität: 08.08.2012 DE 102012107288
(43) Veröffentlichungstag der Anmeldung: 17.06.2015
(73) Patentinhaber: Brose Fahrzeugteile GmbH & Co. Kommanditgesellschaft, Bamberg, 96052 Bamberg (DE)
(72) Erfinder: HERTHAN, Bernd, 96247 Michelau (DE); WEINGARTNER, Thomas, 96117 Memmelsdorf (DE); WURSTLEIN, Holger, 97475 Zeil am Main (DE); GEUTHER, Udo, 96049 Bamberg (DE)
(74) Vertreter: Maikowski & Ninnemann Patentanwälte Partnerschaft mbB
(86) Internationale Anmeldenummer: PCT/EP2013/002290
(87) Internationale Veröffentlichungsnummer: WO 2014/023405

(56) Entgegenhaltungen:
- EP-A2- 0 999 102
- DE-A1-102009 034 549
- DE-A1-102010 049 400
- US-A1- 2008 296 926

## Beschreibung

Die vorliegende Erfindung betrifft ein Verfahren zur Steuerung einer Verstellbewegung eines fremdkraftbetätigt verstellbaren Fahrzeugschließelements, wie z. B. einer Fahrzeugseitentür oder einer Fahrzeugheckklappe, nach dem Anspruch 1 sowie ein Steuerungssystem nach dem Anspruch 11.

Zum Auslösen einer Verstellbewegung eines fremdkraftbetätigt, insbesondere motorisch verstellbaren Fahrzeugschließelements ist es bekannt, berührungslos Bedienereignisse mittels mindestens eines an dem Fahrzeug vorgesehenen Sensorelements zu erkennen, die auf eine Bewegung eines (autorisierten) Benutzers zurückgehen. Hierfür umfasst ein Sensorelement beispielsweise einen Näherungssensor, über den eine Annäherung einer Person bzw. eines Benutzers an das Fahrzeug erfasst und dies gegebenenfalls als Bedienereignis bewertet werden kann, um eine motorische Verstellung des Fahrzeugschließelements zu veranlassen.

Aus der DE 10 2010 049 400 A1 ist beispielsweise bekannt, bei einem Verfahren zur Steuerung einer Verstellbewegung eines Fahrzeugschließelements einen Authentifizierungsprozess auf Basis eines Identifikationsmittels in Form eines Transponders durchzuführen, bevor durch Überwachen eines Nahbereichs in der Umgebung des Fahrzeugs berührungslos ein Auftreten eines Bedienereignisses detektiert wird, um eine Verstellung des Fahrzeugschließelements auszulösen.

Verwandte Verfahren gehen ferner z.B. aus der EP 0 999 102 A2, der DE 10 2009 034 549 A1 und der US 2008/296926 A1 hervor.

Aus der DE 10 2005 032 402 B3 ist beispielsweise bekannt, eine Annäherung einer Person an ein Fahrzeug dadurch zu detektieren, dass zwei räumlich voneinander getrennte Zonen, die unterschiedlich weit entfernt von dem Fahrzeug liegen, dahingehend überwacht werden, ob sich eine Person ausgehend von einer Position in der einen entfernteren Zone in einer vorbestimmten Richtung in die andere, nähere Zone begibt. Wird eine derartige Annäherung anhand der beiden überwachten Zonen festgestellt, wird anschließend automatisch ein Authentifizierungsprozess initiiert, um zusätzlich zu erkennen, ob auch ein gültiges Identifikationsmittel, z. B. ein Funkschlüssel eines Keyless-Entry-Systems, von der sich nähernden Person getragen wird.

Bei dem aus der DE 10 2005 032 402 B3 bekannten Verfahren kann es jedoch dazu kommen, dass jede Annäherung einer das Identifikationsmittel tragenden Person an das Fahrzeug zu einer automatischen Verstellung des Fahrzeugschließmittels, also beispielsweise dem automatischen Öffnen einer Heckklappe führt. Zwar könnten etwaige Fehlauslösungen durch eine komplexere Auswertelogik abgefangen werden, wie beispielsweise indem die Geschwindigkeit der sich nähernden Person und eine etwaige Verharrungszeit in einer der beiden Zonen berücksichtigt werden. Dies ist jedoch vergleichsweise aufwendig und regelmäßig mit höheren Kosten verbunden.

Der vorliegenden Erfindung liegt daher ausgehend von dem genannten Stand der Technik die Aufgabe zugrunde, ein Steuerungsverfahren für die Verstellung eines Fahrzeugschließelements weiter zu verbessern, um die genannten Nachteile zumindest zu minimieren und etwaige Fehlauslösungen effektiver zu vermeiden. Darüber hinaus ist es Aufgabe der vorliegenden Erfindung, ein zugehöriges Steuerungssystem zur Durchführung eines derartigen Verfahrens bereitzustellen.

Diese Aufgabe wird sowohl mit dem Verfahren des Anspruchs 1 als auch mit dem Steuerungssystem des Anspruchs 11 gelöst.

Bei dem erfindungsgemäßen Verfahren zur Steuerung einer Verstellbewegung eines fremdkraftbetätigt verstellbaren Fahrzeugschließelements, wie z. B. einer Seitentür oder einer Heckklappe, über das eine Karosserieöffnung eines Fahrzeugs verschließbar und das zum Freigeben der Karosserieöffnung bei Vorliegen eines Bedienereignisses automatisch verstellt werden kann, ist gemäß dem Anspruch 1 vorgesehen:
- wenigstens einen Fernbereich in der Umgebung des Fahrzeugs mittels mindestens eines ersten Sensorelements des Fahrzeugs zu überwachen, wobei über das mindestens eine erste Sensorelement berührungslos eine Person in dem Fernbereich detektierbar ist;
- einen Authentifizierungsprozess durchzuführen, bei dem das Vorliegen eines gültigen Identifikationsmittels in einem (ggf. zu dem Fernbereich unterschiedlichen) definierten Umgebungsbereich in der Umgebung des Fahrzeugs überprüft wird, wenn über das mindestens eine erste Sensorelement eine Person in dem Fernbereich detektiert wurde;
- einen Nahbereich in der Umgebung des Fahrzeugs mittels mindestens eines zweiten Sensorelements des Fahrzeugs zu überwachen, das zu dem ersten Sensorelement verschieden ist, wobei
   o ein äußerster Rand des Nahbereichs näher an dem Fahrzeug liegt als ein äußerster Rand des Fernbereichs, und
   o über das mindestens eine zweite Sensorelement berührungslos das Auftreten eines Bedienereignisses detektierbar ist, bei dem eine Person mit einem Körperteil eine bestimmte Bewegung in dem überwachten Nahbereich ausführt, und
   o mindestens zwei räumlich voneinander getrennte Nahbereiche überwacht werden, um eine als Bedienereignis zu bewertende Bewegung zu detektieren, wobei der mindestens eine weitere Nahbereich von dem ersten Sensorelement überwacht wird, das auch den Fernbereich überwacht
   und
- das Fahrzeugschließelement zu verstellen, wenn nacheinander eine Person in dem Fernbereich detektiert, ein gültiges Identifikationsmittel in dem Umgebungsbereich erkannt und ein Bedienereignis in dem wenigstens einen Nahbereich detektiert wurde.

Bei dem erfindungsgemäßen Verfahren müssen somit wenigstens drei Bedingungen sukzessiv erfüllt sein, damit auch tatsächlich eine automatische Verstellung des Fahrzeugschließelements erfolgt. Dabei müssen insbesondere zwei Bedingungen in zueinander unterschiedlichen Bereichen, einem Fernbereich einerseits und einem Nahbereich andererseits, erfüllt sein, die durch eine unterschiedliche Reichweite der beiden ersten und zweiten Sensorelemente gekennzeichnet sind.

Während das mindestens eine erste Sensorelement somit eine Annäherung einer Person in einem weiter entfernt von dem Fahrzeug liegenden Fernbereich erkennt (sein äußerster Rand liegt weiter entfernt, der Fernbereich reicht also weiter), beschränkt sich die Überwachung des mindestens einen zweiten Sensorelements auf einen näher an dem Fahrzeug liegenden Nahbereich, der ggf. auch um ein Vielfaches kleiner ist als der überwachte Fernbereich. Erst wenn eine Person in dem mindestens einen überwachten Nahbereich auch eine bestimmte Bewegung ausführt, die als das die Verstellung letztlich auslösendes Bedienereignis mit Hilfe des mindestens einen zweiten Sensorelements bewertet wird, erfolgt auch die fremdkraftbetätigte Verstellung des Fahrzeugschließelements. Etwaige Fehlauslösungen können somit auf einfache Art viel zulässiger ausgeschlossen werden, da mehrere Bedingungen erfüllt sein müssen, von denen wenigstens eine - trotz einer durchweg berührungslosen Steuerung - von einem Benutzer bewusst erfüllt sein muss.

Üblicherweise wird der Umgebungsbereich, in dem auf das Vorliegen eines gültigen Identifikationsmittels, wie z. B. einem Funkschlüssel mit einem eingebauten Transponder, geprüft wird, zu dem Fernbereich und dem mindestens einen überwachten Nahbereich unterschiedlich sein. Dies hängt insbesondere von der Art der verwendeten Sensorik, also z. B. den verwendeten Sendern und Empfängern, ab. Im Zuge einer Weiterbildung des erfindungsgemäßen Verfahrens wird es bevorzugt, wenn die Reichweite zur Erkennung eines gültigen Identifikationsmittels nicht über die Reichweite des Fernbereichs hinausgeht, also der maximal zulässige Abstand zu dem Fahrzeug oder genauer dem zu verstellenden Fahrzeugschließelement, in dem gerade noch eine Erkennung eines gültigen Identifikationsmittels möglich ist, nicht größer ist als der Abstand, bei dem über das mindestens eine erste Sensorelement noch das Detektieren einer Person möglich ist. So ist es auf der Basis der vorliegenden Erfindung vollkommen ausreichend, die Reichweite eines Empfängers zum Erkennen eines gültigen Identifikationsmittels zu begrenzen, wenn ohnehin über das mindestens eine erste Sensorelement sichergestellt wird, dass ein Authentifizierungsprozess erst gestartet wird, wenn sich auch eine Person bereits innerhalb des überwachten Fernbereichs befindet. Hierdurch lassen sich nicht nur Kosten sparen, sondern lässt sich auch der Energieverbrauch eines entsprechenden Steuerungssystems senken.

Im Zuge einer weiteren Energieeinsparung ist in einer Ausführungsvariante auch vorgesehen, dass das mindestens eine zweite Sensorelement zur Überwachung des Nahbereichs erst aktiviert wird, wenn über das mindestens eine erste Sensorelement eine Person in dem Fernbereich detektiert wurde. So ist in dem erfindungsgemäßen Verfahren zur verbesserten Einstellbarkeit an die unterschiedlichen Bereiche zwar bereits vorgesehen, dass das mindestens eine erste Sensorelement für die Überwachung des Fernbereichs und das mindestens eine zweite Sensorelement für die Überwachung des Nahbereichs zueinander unterschiedlich sind. Mit der Aktivierung des zweiten Sensorelements (oder weiterer Sensorelemente) zur Überwachung des Nahbereichs (oder mehrerer Nahbereiche) erst nach der Detektieren einer Person in dem Fernbereich können noch weitere Vorteile erzielt werden. So wird das mindestens eine zweite Sensorelement erst aktiviert, wenn auch sichergestellt ist, dass sich tatsächlich eine Person in dem Fernbereich befindet, und eine Überwachung durch das zweite Sensorelement überhaupt benötigt wird. Ansonsten bleibt das mindestens eine zweite Sensorelement deaktiviert, wodurch sich der Energieverbrauch für das Gesamtsystem reduziert, da der mindestens eine Nahbereich oder auch die mehreren Nahbereich nur bei Bedarf, aber nicht kontinuierlich überwacht werden.

Alternativ oder ergänzend kann vorgesehen sein, dass das mindestens eine zweite Sensorelement (oder mehrere solcher Sensorelemente) zur Überwachung des Nahbereichs (oder mehrerer Nahbereiche) erst aktiviert wird (werden), wenn ein gültiges Identifikationsmittel in dem Umgebungsbereich erkannt wurde. Wird die Erkennung eines gültigen Identifikationsmittels wie auch das Detektieren einer Person in dem überwachten Fernbereich dem Aktivieren des mindestens einen zweiten Sensorelements vorgelagert, werden etwaige unnötige Aktivierungen des mindestens einen zweiten Sensorelements weiter minimiert.

Erfindungsgemäß ist ferner vorgesehen, dass mindestens zwei räumlich voneinander getrennte Nahbereiche überwacht werden, um eine als Bedienereignis zu wertende Bewegung zu detektieren. Jeder dieser Nahbereiche liegt mit seinem äußersten Rand jeweils näher an dem Fahrzeug als ein äußerster Rand des Fernbereichs und ist somit dazu eingerichtet und vorgesehen, Bewegungen eines Benutzers in unmittelbarer Nähe des Fahrzeugs vorzugsweise sogar nur in unmittelbarer Nähe des zu verstellenden Fahrzeugschließelements zu detektieren.

Indem zwei räumlich voneinander getrennte Nahbereiche überwacht werden, ist die Vorgabe komplexerer Bewegungen möglich, die als Bedienereignis gewertet werden und letztlich zum Verstellen des Fahrzeugschließelements führen. Ein Beispiel einer derartigen komplexeren Bewegung ist die Ausführung einer Hin- und Herbewegung eines Fußes im Bereich eines Stoßfängers am Heck eines Kraftfahrzeugs nach Art eines "Kicks". Eine solche Bewegung ist erfahrungsgemäß erst durch die berührungslose Überwachung zweier räumlich voneinander separierter Nahbereiche zuverlässig zu erkennen. Dabei deckt beispielsweise ein Nahbereich einen Bereich unmittelbar vor dem Stoßfänger und der zweite Nahbereich einen Bereich unterhalb des Stoßfängers in Richtung der Fahrbahnoberfläche ab. Erst wenn durch die Überwachung beider Nahbereiche charakteristische Messsignale generiert werden, die einerseits auf das Vorliegen eines Unterschenkels vor dem Stoßfänger und andererseits auf das Einführen eines Fußes in dem Bereich zwischen Stoßfänger und Fahrbahnoberfläche und das anschließende Zurückziehen dieses Fußes schließen lassen (also die Ausführung einer "Kick"-Bewegung), wird dies als das Auftreten eines Bedienereignisses gewertet, das - bei vorangegangener Erfüllung der wenigstens zwei anderen Bedingungen - zum Verstellen des Fahrzeugschließelements führt. Entscheidend ist hier jeweils, dass ein Benutzer das Fahrzeugschließelement nicht manuell betätigen muss, sondern die Verstellung durch eine berührungslose Erfassung elektronisch ausgelöst wird.

Hierzu können die einzelnen Sensorelemente beispielsweise kapazitive oder optische Sensoren und/oder Ultraschall- oder Mikrowellensensoren umfassen.

Für eine beispielhafte und nicht erfindungsgemäße Überwachung der mindestens zwei räumlich voneinander getrennten Nahbereiche kann vorgesehen sein, dass der mindestens eine weitere Nahbereich von einem anderen Sensorelement überwacht wird. Bei diesem anderen Sensorelement kann es sich um mindestens ein weiteres, drittes Sensorelement handeln, das sowohl zu dem mindestens einen ersten Sensorelement als auch zu dem mindestens einen zweiten Sensorelement verschieden ist.

Erfindungsgemäß ist demgegenüber vorgesehen, dass der mindestens eine weitere Nahbereich von dem ersten Sensorelement überwacht wird, das auch den Fernbereich überwacht. Ein derartiges erstes Sensorelement kann somit beispielsweise Sensoren unterschiedlicher Reichweite integrieren, die einerseits für die Überwachung des Fernbereichs und andererseits für die Überwachung eines zweiten Nahbereichs ausgelegt und vorgesehen sind. In einer anderen Ausführungsvariante kann das erste Sensorelement schaltbar sein, so dass es nach dem Detektieren einer Person in dem Fernbereich und der erfolgreichen Erkennung eines gültigen Identifikationsmittels in einen anderen Modus geschaltet wird, in der das erste Sensorelement nicht mehr den Fernbereich, sondern ausschließlich noch den mindestens einen weiteren Nahbereich überwacht, um das Auftreten eines Bedienereignisses feststellen zu können.

Zur bauraumsparenden Unterbringung der einzelnen Sensorelemente sind diese als Teil einer gemeinsamen Sensoreinrichtung elektronisch (ggf. über eine elektronische Steuerungseinheit und/oder eine gemeinsame Stromversorgung) miteinander gekoppelt.

Darüber hinaus hat es sich als vorteilhaft herausgestellt, die unterschiedlichen Sensorelemente auf einer gemeinsamen Leiterplatte vorzusehen. So kann beispielsweise ein zweites Sensorelement mit einem kapazitiven Sensor zur Überwachung eines Nahbereichs mit einem Sensorelement zur Überwachung eines Fernbereichs, das einen Mikrowellensensor und einen zugeordneten Empfänger umfasst, auf derselben Leiterplatte angeordnet sein. Bei der Überwachung eines Heckbereichs eines Kraftfahrzeugs für die automatische Verstellung einer Kraftfahrzeugheckklappe sind die einzelnen Sensorelemente bevorzugt im Bereich des Hecks des Kraftfahrzeugs untergebracht, besonders bevorzugt im Bereich des Stoßfängers.

In einer Ausführungsvariante kann mittels des mindestens einen Sensorelements für die Überwachung des Fernbereichs detektiert werden bzw. durch dieses Sensorelement detektierbar sein, ob sich eine innerhalb des Fernbereichs befindliche Person dem Fahrzeug nähert. Es wird hier also nicht nur festgestellt, ob sich eine Person in dem Fernbereich befindet, oder in diesen eintritt, sondern auch ob eine Annäherung dieser Person an das Fahrzeug, vorzugsweise an das zu verstellende Fahrzeugschließelement, stattfindet. Eine derartige Annäherung kann beispielsweise durch wiederholte (zyklische) Messungen eines Abstandes mittels dieses mindestens einen ersten Sensorelements erfolgen, ggf. unter Nutzung des Dopplereffekts. Eine weitere Möglichkeit stellt die aus der DE 10 2005 032 402 B3 bekannte und eingangs kurz erläuterte Überwachung unterschiedlicher Zonen innerhalb des Fernbereichs dar.

Um einer Person bei einer Annäherung an das Fahrzeug den aktuellen Status bzw. die Aktivierung einzelner Komponenten des Steuerungssystems zu signalisieren, ist in einer Weiterbildung des erfindungsgemäßen Verfahrens vorgesehen, dass nach dem Detektieren einer Person in dem Fernbereich oder nach der sich daran anschließenden Erkennung eines gültigen Identifikationsmittels in dem Umgebungsbereich mittels einer Hinweiseinrichtung eine visuell und/oder akustisch wahrnehmbare Meldung an dem Fahrzeug ausgegeben wird. Hierüber wird der sich dem Fahrzeug nähernden Person bzw. dem sich dem Fahrzeug nähernden autorisierten Benutzer eine Rückmeldung darüber gegeben, inwieweit das Steuerungssystem aktiviert wurde und insbesondere ob es dazu bereit ist, eine Verstellung des Fahrzeugschließelements zu veranlassen, wenn letztlich auch noch das als Bedienereignis hinterlegte Bewegungsmuster in unmittelbarer Nähe des Fahrzeugs ausgeführt wird. Über die visuell und/oder akustisch wahrnehmbare Meldung wird dem Benutzer also signalisiert, ob die für die Verstellung erforderlichen Bedingungen von dem Steuerungssystem als erfüllt angesehen werden.

Eine solche Hinweiseinrichtung umfasst vorzugsweise ein beleuchtetes Hinweiselement und/oder ein zur Beleuchtung vorgesehenes Hinweiselement an dem Fahrzeug. Bei einem beleuchteten Hinweiselement kann es sich beispielsweise um eine separate Signallampe, die Innenbeleuchtung, eine Rückleuchte oder einen Blinker handeln. Ein zur Beleuchtung vorgesehenes Hinweiselement ist beispielsweise ein Spot oder ein Scheinwerfer, mittels dem bevorzugt wenigstens der überwachte Nahbereich oder wenigstens einer der überwachten Nahbereiche be- oder sogar ausgeleuchtet wird. Mit der Aktivierung eines zur Beleuchtung vorgesehenen Hinweiselements ist somit ein sichtbarer Hinweis verbunden, wo eine Überwachung stattfindet und eine als Bedienereignis zu wertende Bewegung ausgeführt werden muss, damit das Steuerungssystem diese erkennen kann. Über eine derartige Hinweiseinrichtung weiß somit ein Benutzer, in welchem Bereich an oder um das Fahrzeug er überhaupt ein Bedienereignis zur Verstellung des Fahrzeugschließelements auslösen kann.

Alternativ oder ergänzend kann auch vorgesehen sein, einen Ton oder eine hörbare Nachricht auszugeben, um z. B. über die Erkennung eines gültigen Identifikationsmittels oder eines gültigen Bedienereignisses zu informieren.

Für die Information über das Erkennen eines gültigen Bedienereignisses kann in einer Ausführungsvariante auch vorgesehen sein, dass ein (beleuchtetes oder zur Beleuchtung vorgesehenes) Hinweiselement seine Helligkeit und/oder seine Lichtfarbe verändert, wenn ein Bedienereignis detektiert wurde. So kann beispielsweise vorgesehen sein, dass das jeweilige Hinweiselement blinkt, um das erfolgreiche Detektieren eines Bedienereignisses anzuzeigen. Dabei ist es aber selbstverständlich auch möglich, dass ein blinkendes Hinweiselement zur Ausgabe einer visuell wahrnehmbaren Meldung vor dem Detektieren eines Bedienereignisses verwendet ist, um das vorhergehende Aktivieren der Überwachung des Nahbereichs bzw. der Nahbereiche zu signalisieren.

Wie bereits zuvor erläutert, handelt es sich bei dem Fahrzeugschließelement vorzugsweise um eine Seitentür oder eine Heckklappe eines Kraftfahrzeugs.

Ferner ist ein Identifikationsmittel, dessen Vorliegen im Rahmen des Authentifizierungsprozesses überprüft wird, bevorzugt ein Funkschlüssel des Fahrzeugs, vorzugsweise ein Funkschlüssel eines Keyless-Entry-Systems. Ein solcher Funkschlüssel kann dabei beispielsweise einen integrierten Transponder umfassen, um mittels entsprechender Codierung und Decodierung einen Authentifizierungsprozess zwischen Fahrzeug und Funkschlüssel durchführen zu können. Derartige Systeme sind weithin bekannt, so dass auf eine weitere Erläuterung hierzu in der vorliegenden Anmeldung verzichtet wird.

Ein weiterer Aspekt der vorliegenden Erfindung ist die Bereitstellung eines Steuerungssystems für eine motorische Verstelleinrichtung zum Verstellen eines Fahrzeugschließelements, insbesondere zur Durchführung eines erfindungsgemäßen Verfahrens.

Bei diesem Steuerungssystem gemäß dem Anspruch 11 ist insbesondere eine elektronische Steuereinrichtung vorgesehen, die zusätzlich zur Durchführung eines Authentifizierungsprozesses dazu eingerichtet und vorgesehen ist, automatisch eine Verstellung des Fahrzeugschließelements zu veranlassen, wenn nacheinander über mindestens ein erstes Sensorelement des Steuerungssystems eine Person in einem Fernbereich detektiert, ein gültiges Identifikationsmittel in einem Umgebungsbereich erkannt und eine als Bedienereignis zu bewertende Bewegung in den mindestens zwei räumlich voneinander getrennten Nahbereichen detektiert wurde.

Teil eines derartigen Steuerungssystems können insbesondere kapazitive und/oder optische Näherungssensoren sein sowie auch eine Hinweiseinrichtung der oben beschriebenen Art.

Da sich ein erfindungsgemäßes Steuerungssystem auch für die Durchführung eines erfindungsgemäßen Verfahrens eignet, gelten die im Zusammenhang mit dem Verfahren beschriebenen Merkmale und Vorteile auch für ein erfindungsgemäßes Steuerungssystem und dessen mögliche Ausführungsvarianten und umgekehrt.

Darüber hinaus sei darauf verwiesen, dass unter einem fremdkraftbetätigte Verstellen eines Fahrzeugschließelements insbesondere jedes motorische Verstellen verstanden wird, also insbesondere die Verstellung mittels eines Elektromotors, Hydraulikmotors und/oder Pneumatikmotors.

Weitere Vorteile und Merkmale der vorliegenden Erfindung werden bei der nachfolgenden Beschreibung von Ausführungsbeispielen anhand der Figuren deutlich werden.

Hierbei zeigen:
- Figur 1A: ausschnittsweise ein Kraftfahrzeug mit einem Fahrzeugschließelement in Form einer Seitentür, die gemäß einer Ausführungsvariante der vorliegenden Erfindung automatisch verstellbar ist;
- Figur 1B: ausschnittsweise ein Kraftfahrzeug mit einem Fahrzeugschließelement in Form einer Heckklappe, die gemäß einer Ausführungsvariante der vorliegenden Erfindung automatisch verstellbar ist;
- Figur 2A: schematisch die Anordnung und die überwachten Bereiche eines Ausführungsbeispiels eines erfindungsgemäßen Steuerungssystems für die automatische Verstellung einer Heckklappe;
- Figuren 2B-2C: schematisch eine Weiterbildung des Steuerungssystems der Figur 2A mit einer Hinweiseinrichtung für die Generierung visuell wahrnehmbarer Hinweise für einen Benutzer, durch die ein Benutzer über die Aktivierung und die Funktion des Steuerungssystems informiert wird;
- Figur 3: ein Ablaufschema einer Ausführungsvariante für ein erfindungsgemäßes Verfahren;
- Figuren 4A-4C: drei weitere Varianten eines erfindungsgemäßen Steuerungssystems.

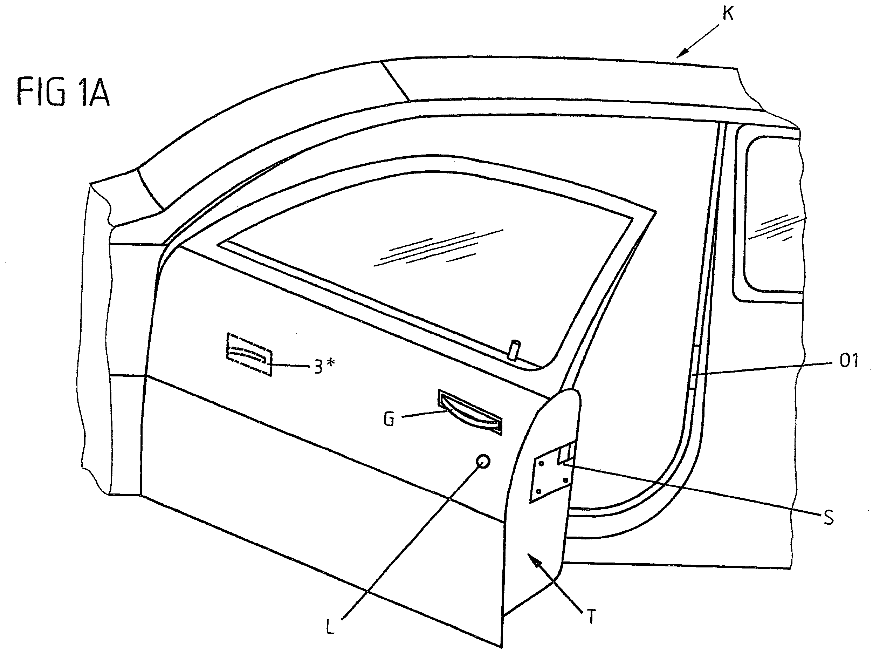

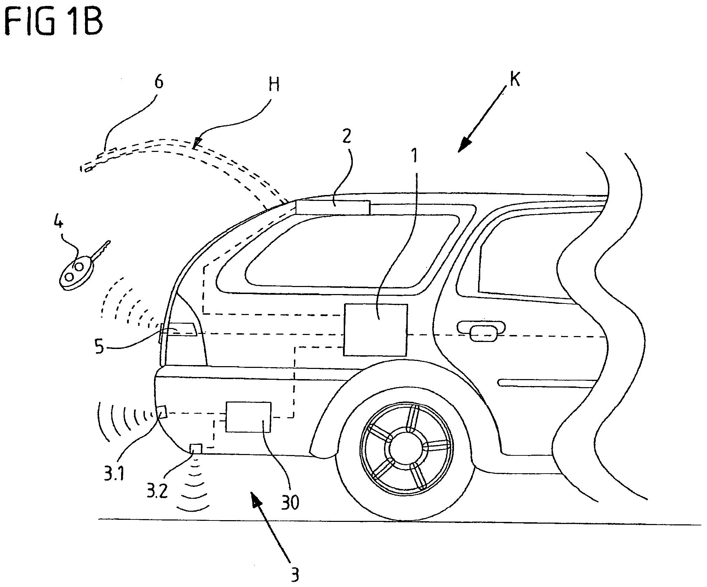

In den Figuren 1A und 1B ist jeweils ausschnittsweise ein Kraftfahrzeug K dargestellt, bei dem jeweils eine Karosserieöffnung O1 und O2 durch ein Fahrzeugschließelement in Form einer Seitentür T bzw. in Form einer Heckklappe H verschließbar ist. Die Seitentür T und die Heckklappe H sind vorliegend über eine Ausführungsvariante eines erfindungsgemäßen Steuerungssystems zum Freigeben der jeweiligen Karosserieöffnung O1, O2 bei Vorliegen eines berührungslos erfassten Bedienereignisses automatisch verstellbar. Die dargestellten Fahrzeugschließelemente T und H sind mittels einer motorischen Antriebseinheit selbsttätig in eine abgeklappte oder verschwenkte Lage überführbar, in der sie die jeweilige Karosserieöffnung O1 bzw. O2 freigeben. In einer Ausführungsvariante können die Seitentür T und/oder die Heckklappe H auch wieder automatisch mittels einer motorischen Antriebseinheit geschlossen werden.

Die in der Figur 1A dargestellte Seitentür T ermöglicht über ein Schlüsselloch L und einen Türgriff G das Entriegeln eines Schlosses S in einem geschlossenen Zustand der Seitentür T und das manuelle Öffnen durch einen Benutzer. Zusätzlich ist über eine hier nicht dargestellte motorische Antriebseinheit ein automatisches Öffnen (und Schließen) der Seitentür T möglich.

Hierbei wird über eine Sensoreinrichtung 3* berührungslos insbesondere das Auftreten eines Bedienereignisses durch die Ausführung einer bestimmten Bewegung mit einem Körperteil in der Umgebung der Seitentür T festgestellt. Die Sensoreinrichtung 3* ist in die Seitentür T integriert und überwacht mittels zweier unterschiedlicher hier nicht dargestellter erster und zweiter Sensorelemente, beispielsweise mit optischen und/oder kapazitiven Näherungssensoren sowohl einen Fernbereich als auch einen Nahbereich in der Umgebung des Kraftfahrzeugs K und vorzugsweise ausschließlich in der Umgebung der Seitentür T. Über die Sensoreinrichtung 3* und die darin vorgesehenen Sensorelemente ist einerseits eine Person in einem Fernbereich, d. h., in einem größeren Abstand zu dem Kraftfahrzeug K, detektierbar. Wird in diesem Fernbereich eine Person detektiert und gegebenenfalls sogar eine Annäherung an die Seitentür T festgestellt, wird über eine mit der Sensoreinrichtung 3* gekoppelte elektronische Steuereinrichtung (in Fig. 1A nicht dargestellt) oder über eine die Sensoreinrichtung 3* integrierende Steuereinrichtung ein Authentifizierungsprozess gestartet, bei dem das Vorliegen eines gültigen Identifikationsmittels in einem Umgebungsbereich um das Kraftfahrzeug K geprüft wird.

Ist das Ergebnis dieser Überprüfung positiv, d. h., wird beispielsweise anhand des Austauschs kodierter Signale das Vorliegen eines gültigen Identifikationsmittels erkannt, werden für die Überwachung eines Nahbereichs in unmittelbarer Nähe der Seitentür T vorgesehene zweite Sensorelemente aktiviert. Über diese zweiten Sensorelemente ist beispielsweise eine bestimmte Bewegung eines Benutzers mit seiner Hand, seinem Arm oder seinem Fuß anhand damit einhergehender charakteristischer Messsignale erfassbar, die als Bedienereignis in der elektronischen Steuereinrichtung hinterlegt sind und letztlich die Verstellung der Seitentür T - vorzugsweise deren Öffnen - auslösen. Ein äußerster Rand eines überwachten Nahbereichs liegt dabei beispielsweise weniger als einen Meter von der Seitentür entfernt, so dass nur in einem Radius von weniger als einem Meter das Auftreten eines Bedienereignisses erfasst werden kann. So kann beispielsweise vorgesehen sein, dass über mindestens ein hier nicht ersichtliches zweites Sensorelement der Sensoreinrichtung 3* im unteren Teil des Türrahmens oder der der Fahrbahnoberfläche zugewandten Karosserieunterseite eine Hin- und Herbewegung einer Hand oder eines Fußes des Benutzers nach Art eines "Kicks" erfasst und als Bedienereignis bewertet wird.

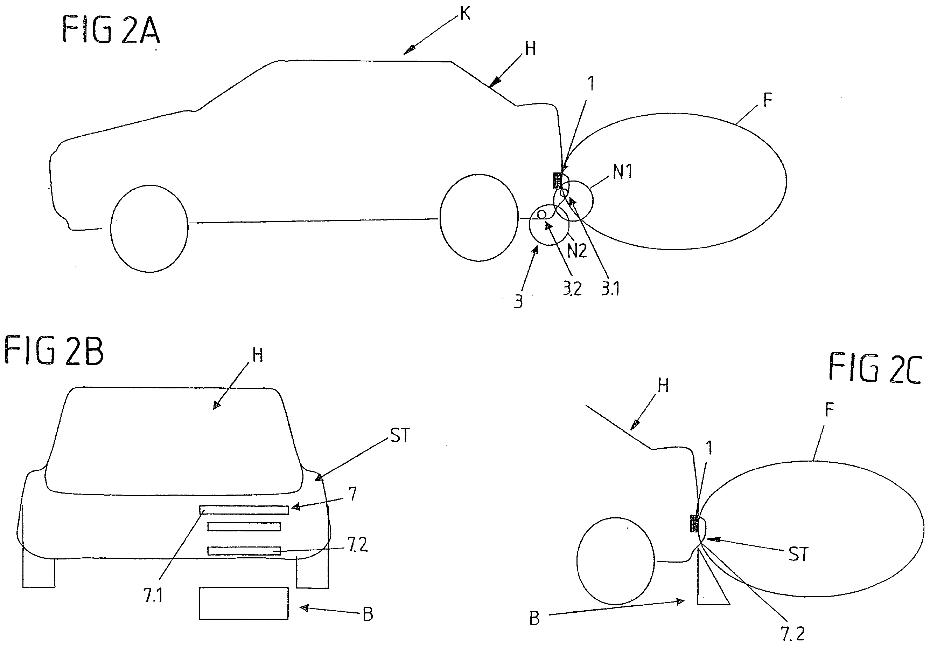

Weitere Details und Merkmale des Steuerungssystems der Figur 1A und des damit umgesetzten Steuerungsverfahrens werden im Zusammenhang mit der nachfolgenden Beschreibung einer Ausführungsvariante noch deutlicher werden, bei der eine automatische Verstellung einer Heckklappe H eines Kraftfahrzeugs K als Fahrzeugschließelement erfolgt. So ist die in der Figur 1B (und auch in den Figuren 2A-2C) ersichtliche Heckklappe H des Kraftfahrzeugs K in analoger Weise wie die Seitentür T der Figur 1A automatisch zu verstellen.

Die für die Verstellung der Heckklappe H vorgesehene Sensoreinrichtung 3 des Steuerungssystems ist dabei im Bereich eines Stoßfängers ST am Heck des Kraftfahrzeugs K angeordnet und mit einer elektronischen Steuereinrichtung 1 des Steuerungssystems gekoppelt. Die Sensoreinrichtung 3 empfängt die von den Sensorelementen 3.1, 3.2 erzeugten Signale und bewertet diese dahingehend, ob in einem von einem ersten Sensorelement 3.1 überwachten Fernbereich eine Person detektiert wurde und ob in einem von einem hierzu verschiedenen zweiten Sensorelement 3.2 überwachten Nahbereich ein Bedienereignis aufgetreten ist, nachdem zwischenzeitlich auch ein gültiges Identifikationsmittel in Form eines Funkschlüssels 4 in der Umgebung des Kraftfahrzeugs K erkannt wurde. Erst wenn die sukzessiv abgeprüften Bedingungen vorliegen und letztlich auch ein gültiges Bedienereignis erfasst wurde, erfolgt die Verstellung der Heckklappe H mithilfe der Steuereinrichtung 1.

Auch die Sensoreinrichtung 3 ist somit mittels ihrer wenigsten zwei räumlich zueinander beabstandeten Sensorelemente 3.1 und 3.2 dazu in der Lage, berührungslos vor Verstellung der Heckklappe H notwendige Bedingungen abzuprüfen, damit etwaige Fehlauslösungen effektiv vermieden werden. Dabei werden in dem vorliegenden Ausführungsbeispiel die von den beiden Sensorelementen 3.1, 3.2 erfassten Messsignale an eine Auswerteeinheit 30 der Sensoreinrichtung 3 weitergeleitet, die diese dann an die Steuereinrichtung 1 sendet. In einer alternativen Ausführungsvariante kann selbstverständlich vorgesehen sein, dass die Auswerteeinheit 30 entfällt und Signale der Sensorelemente 3.1, 3.2 direkt an die Steuereinrichtung 1 übermittelt werden.

Die Steuereinrichtung 1 ist vorliegend noch mit einem Schlüsseldetektor 5 gekoppelt oder in einer alternativen Ausführungsvariante mit diesem ausgestattet, um einen Authentifizierungsprozess durchzuführen, bei dem überprüft wird, ob in einem definierten Umgebungsbereich um das Kraftfahrzeug K herum ein gültiges Identifikationsmittel in Form eines Funkschlüssels 4 vorliegt. Es wird folglich ein Authentifizierungsprozess durchgeführt, um festzustellen, ob auch tatsächlich ein autorisierter Benutzer in der Umgebung des Kraftfahrzeugs K vorliegt, bevor die Heckklappe H geöffnet wird. Ein solcher Funkschlüssel 4 ist vorzugsweise Teil eines so genannten Keyless-Entry-Systems und kann beispielsweise einen Transponder umfassen.

Die Verstellung der Heckklappe H auf ein Verstellsignal der Steuereinrichtung 1 hin, wird vorliegend durch eine motorische Antriebseinheit 2 durchgeführt, mittels derer die Heckklappe H geöffnet und vorzugsweise auch geschlossen werden kann.

Bevorzugt werden die Sensoreinrichtung 3, die die Signale der Sensorelemente 3.1, 3.2 auswertet, und die Steuereinrichtung 1, die die Signale des Schlüsseldetektors 5 auswertet, in einem einzigen Steuergerät integriert.

Die Funktionsweise des in der Figur 1B dargestellten Steuerungssystems ist insbesondere in der Figur 2A noch näher veranschaulicht. So ist in der Figur 2A der von dem ersten Sensorelement 3.1 der Sensoreinrichtung 3 überwachte Fernbereich F sowie ein Nahbereich N2 ersichtlich, der von dem zweiten Sensorelement 3.2 überwacht wird. Der am Heck des Kraftfahrzeugs K überwachte Fernbereich F ist vorliegend um ein Vielfaches größer als der Nahbereich N2 und auch der äußerste Rand des Fernbereichs F ist deutlich weiter entfernt als ein äußerster Rand des Nahbereichs N2. Dies bedeutet mit anderen Worten, dass über das erste Sensorelement 3.1 eine Person oder gegebenenfalls deren Bewegung in einem viel größeren Abstand zu dem Heck des Kraftfahrzeugs K detektierbar ist als über das zweite Sensorelement 3.2.

In einer Variante ist bei abgestelltem Kraftfahrzeug K ausschließlich das erste Sensorelement 3.1 zur Überwachung des Fernbereichs F aktiv geschaltet. Wird nun über das Sensorelement 3.1 (und die zugehörige Bewertung über die elektronische Steuereinrichtung 1) eine Person in dem Fernbereich F detektiert, wird ein Authentifizierungsprozess gestartet. Hierdurch wird vermieden, dass eine etwaige Verstellung der Heckklappe H erfolgt, ohne dass ein autorisierter Benutzer des Kraftfahrzeugs K in der Nähe des Kraftfahrzeugs K ist und somit eventuell eine missbräuchliche Verstellung der Heckklappe H erfolgen soll. Hierbei wird über den Schlüsseldetektor 5 folglich das Vorliegen des Funkschlüssels 4 in der Umgebung des Kraftfahrzeugs K überprüft.

Erst wenn in dem Authentifizierungsprozess festgestellt wurde, dass ein gültiger Funkschlüssel 4 vorliegt, wird das bisher inaktive zweite Sensorelement 3.2 aktiviert. Im vorliegenden Fall kann zusätzlich auch noch das erste Sensorelement 3.1 in einen Betriebsmodus geschaltet werden, in den es alternativ oder zusätzlich zu der Überwachung des Fernbereichs F einen weiteren, zweiten Nahbereich N1 hinter dem Stoßfänger ST überwacht. So kann über die Überwachung der beiden räumlich zueinander beabstandeten Nahbereiche N1, N2, einerseits vor dem Stoßfänger ST und andererseits unterhalb des Stoßfängers ST, eine charakteristische Fußbewegung eines (autorisierten) Benutzers festgestellt werden, die als Auftreten eines Bedienereignisses bewertet wird und letztlich zum Öffnen der Heckklappe H führt, ohne dass der Benutzer das Kraftfahrzeug K oder die Heckklappe H berühren muss. Eine als Bedienereignis bewertete charakteristische Bewegung eines Fußes wäre beispielsweise eine Hin- und Herbewegung nach Art eines "Kicks", bei der von den beiden Sensorelementen 3.1, 3.2 hierfür charakteristische Messsignale geliefert werden.

Indem erfindungsgemäß das Vorliegen einzelner Bedingungen nacheinander abgeprüft wird, bevor eine Verstellung der Heckklappe H (oder der Seitentür T) erfolgt, können etwaige Fehlauslösungen oder missbräuchliche Betätigungen zuverlässig ausgeschlossen werden. Indem darüber hinaus das zweite Sensorelement 3.2 erst aktiviert wird, wenn zuvor eine Person in dem überbewachten Fernbereich F detektiert wurde und sogar erst wenn auch zusätzlich ein gültiger Funkschlüssel 4 erkannt wurde, lässt sich der Energieverbrauch eines erfindungsgemäßen Steuerungssystems entscheidend senken.

Um einen Benutzer darüber hinaus visuell und/oder akustisch über den Status der Sensoreinrichtung 3 bzw. 3* und/oder über einen überwachten Bereich, indem ein Bedienereignis erkannt werden muss, zu informieren, ist in einer möglichen Weiterbildung vorgesehen, eine Hinweiseinrichtung 7 an dem Kraftfahrzeug K als Teil des Steuerungssystems auszubilden. Eine solche Hinweiseinrichtung 7 verfügt dann über Hinweiselemente z.B. in Form von Beleuchtungsmitteln, wie Leuchtdioden, um einen Benutzer auf den jeweiligen Status der Sensoreinrichtung 3, 3* hinzuweisen. Alternativ oder ergänzend kann eine derartige Hinweiseinrichtung 7 selbstverständlich auch dazu in der Lage sein, eine akustische Meldung auszugeben.

In den Figuren 2B und 2C ist eine Hinweiseinrichtung 7 exemplarisch dargestellt. Diese Hinweiseinrichtung 7 weist hier mehrere Hinweiselemente 7.1, 7.2 in Form von Leuchtstreifen (Hinweiselement 7.1) und gerichteter Leuchtmittel (Hinweiselement 7.2) auf. Bei dem Hinweiselement 7.1 handelt es sich somit um ein beleuchtetes Hinweiselement, während das Hinweiselement 7.2 zur Be- oder Ausleuchtung eines bestimmten Bereichs in der Umgebung des Kraftfahrzeugs ausgebildet und vorgesehen ist.

Über ein Hinweiselement 7.1 kann beispielsweise im Bereich des Stoßfängers ST über unterschiedliche Farben oder unterschiedliche Anzahlen von beleuchteten Segmenten und/oder wechselnde Lichtfarben ein Benutzer darauf hingewiesen werden, ob die Sensoreinrichtung 3 des Steuerungssystems aktiviert ist oder welches der Sensorelemente 3.1, 3.2 aktiviert ist. Insbesondere kann eine visuell wahrnehmbare Meldung ausgegeben werden, ob eine Person in dem Fernbereich F erfolgreich detektiert wurde und/oder ob ein gültiger Funkschlüssel 5 in dem Umgebungsbereich erkannt wurde.

Über das Hinweiselement 7.2 kann ferner - nach Aktivierung der Sensorelemente 3.1, 3.2 für die Überwachung der jeweiligen Nahbereiche N1, N2 - ein Hinweisbereich B ausgeleuchtet werden. Über diesen ausgeleuchteten Hinweisbereich B wird ein Benutzer darüber informiert, an welcher Stelle er mit seinem Fuß im Bereich des Stoßfängers ST eine bestimmte Bewegung auszuführen hat, damit diese als Bedienereignis zum Öffnen der Heckklappe H bewertet werden kann. Der Hinweisbereich B ist dabei bevorzugt nahezu deckungsgleich mit dem überwachten Nahbereich N2.

Alternativ oder ergänzend kann eine Rückleuchte 6 oder ein Blinker am Heck des Kraftfahrzeugs K Teil einer derartigen Hinweiseinrichtung 7 sein, um einen Nutzer visuell über Status und/oder Funktion der Sensoreinrichtung 3 bzw. der Sensorelemente 3.1, 3.2 zu informieren. Auch kann die Innenbeleuchtung Teil einer derartigen Hinweiseinrichtung 7 sein, indem diese beispielsweise aktiviert wird, wenn erfolgreich das Auftreten eines Bedienereignisses im Bereich des Stoßfängers ST erkannt wurde.

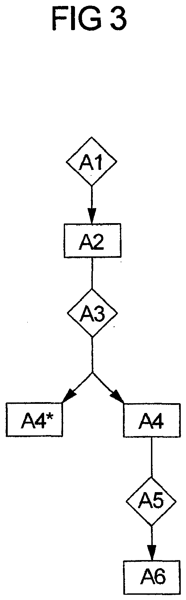

Mit der Figur 3 wird noch exemplarisch eine mögliche Ausführungsvariante eines erfindungsgemäßen Verfahrens anhand eines Ablaufschema veranschaulicht. Dabei sind hierin einzelne Verfahrensschritte A1 bis A6 gezeigt.

So beginnt das Verfahren mit einem Verfahrensschritt A1, in dem über das erste Sensorelement 3.1 eine Person in dem von ihm überwachten Fernbereich F detektiert wird, beispielsweise durch Annäherung einer Person an das Kraftfahrzeug K. In einem nachfolgenden Verfahrensschritt A2 wird nun das Vorliegen eines gültigen Identifikationsmittels, wie dem Funkschlüssel 4, in der Umgebung des Kraftfahrzeugs K überprüft, um festzustellen, ob sich ein autorisierte Benutzer, der den Funkschlüssel 4 trägt, in der Nähe des Kraftfahrzeugs K befindet. Wird dann in einem Verfahrungsschritt A3 beispielsweise mittels der elektronischen Steuereinrichtung 1 ein gültiges Identifikationsmittel erkannt, erfolgt in einem nachfolgendem Verfahrensschritt A4 die Aktivierung des bisher inaktiven zweiten Sensorelements 3.2 zur Überwachung des Nahbereichs N2 unterhalb des Stoßfängers ST. Gleichzeitig wird entweder das erste Sensorelement 3.1 auch für die Überwachung des weiteren Nahbereichs N1 vor dem Stoßfänger ST aktiv geschaltet oder umgeschaltet. Alternativ kann auch ein weiteres, drittes Sensorelement zur ausschließlichen Überwachung des weiteren Nahbereichs N1 vorgesehen sein und in dem Verfahrensschritt A4 aktiviert werden.

Darüber hinaus sei erwähnt, dass es selbstverständlich auch möglich ist, dass die von den einzelnen Sensorelementen 3.1, 3.2 bzw. einem dritten hier nicht dargestellten Sensorelement überwachten Nahbereiche N1, N2 im Bereich des Stoßfängers ST auch zu dem in der Figur 2A exemplarisch dargestellten Nahbereichen N1, N2 abweichen und beispielsweise miteinander vertauscht sein können.

Wird über die nun zur Nahbereichs-Überwachung aktiven Sensorelemente 3.1, 3.2 ein gültiges Bedienereignis, z.B. ein "Kick", berührungslos im Bereich des Stoßfängers ST erfasst und als solches von der elektronischen Steuereinrichtung 1 bewertet (Verfahrensschritt A5), wird in einem darauffolgendem Verfahrensschritt A6 durch die elektronische Steuereinrichtung 1 die Verstellung - hier das Öffnen - der Heckklappe H veranlasst.

Gleichzeitig mit der Aktivierung der Sensorik für die Überwachung des einen oder der mehreren Nahbereiche N1, N2 kann die zusätzliche Aktivierung der Hinweiseinrichtung 7 erfolgen, wie dies in dem Ablaufschema der Figur 3 mit dem Verfahrensschritt A4* veranschaulicht ist.

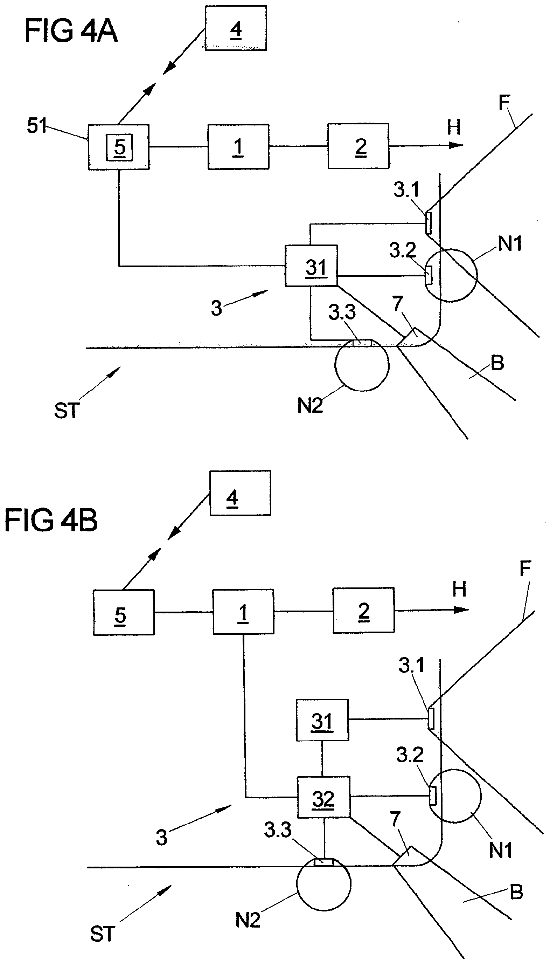

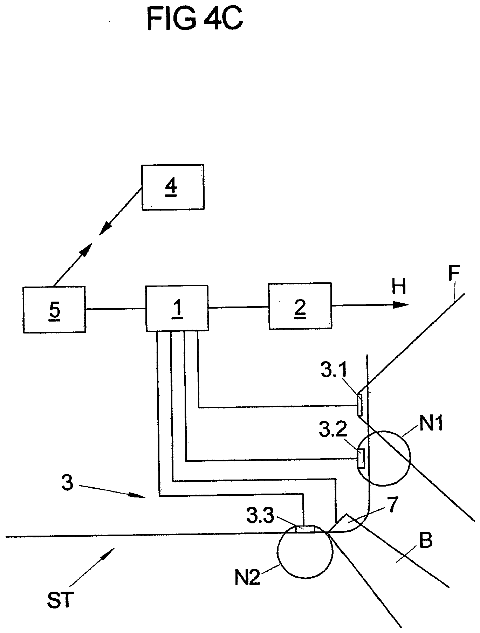

Mit den Figuren 4A, 4B und 4C werden exemplarisch drei weitere Varianten eines erfindungsgemäßen Steuerungssystems veranschaulicht.

Bei der nicht erfindungsgemäßen Variante der Figur 4A ist die Sensoreinrichtung 3 im Bereich des Stoßfängers ST am Heck des Kraftfahrzeugs K mit einem ersten Steuergerät 31 ausgeführt, das erste, zweite und dritte Sensorelemente 3.1, 3.2 und 3.3 zur Überwachung des Fernbereichs F und der beiden Nahbereiche N1 und N2 steuert und deren Signale auswertet. Die Überwachung des Fernbereichs F übernimmt in dieser Variante das erste Sensorelement 3.1, während für die Überwachung der beiden Nahbereiche N1, N2 je ein zusätzliches Sensorelement 3.2, 3.3 vorgesehen ist. Darüber hinaus wird hier die Hinweiseinrichtung 7 von dem ersten Steuergerät 31 bzw. der Sensoreinrichtung 3 gesteuert.

Die Sensoreinrichtung 3 ist mit einem zweiten Steuergerät 51, vorzugsweise eines Keyless-Entry-Systems, gekoppelt, das den Schlüsseldetektor 5 umfasst.

Das zweite Steuergerät 51 ist wiederum noch mit der Steuereinrichtung 1 als einem dritten Steuergerät gekoppelt, das den Antrieb 2 zum Öffnen und Schließen der Heckklappe H steuert.

Bei der nicht erfindungsgemäßen Variante der Figur 4B umfasst die Sensoreinrichtung 3 zwei Steuergeräte 31 und 32. Ein erstes Steuergerät 31 steuert und wertet Signale von und an das erste Sensorelement 3.1 zur Überwachung des Fernbereichs F aus. Ein zweites Steuergerät 32 steuert und wertet Signale von und an die zweiten und dritten Sensorelemente 3.2, 3.3 sowie die Hinweiseinrichtung 7 aus.

Bei der nicht erfindungsgemäßen Variante 4C ist lediglich ein einzelnes (Heckklappen-) Steuergerät in Form der Steuereinrichtung 1 am Heck des Kraftfahrzeugs K untergebracht, über das sowohl das erste Sensorelement 3.1 zur Überwachung des Fernbereichs F als auch das zweite und dritte Sensorelement 3.2, 3.3 zur Überwachung der Nahbereiche N1, N2 gesteuert und deren Signale ausgewertet werden. Zusätzlich steuert die Steuereinrichtung 1 hier auch die Hinweiseinrichtung 7 und den Antrieb 2.

### Bezugszeichenliste

- 1: Steuereinrichtung
- 2: Antrieb
- 3, 3*: Sensoreinrichtung
- 3.1: Erstes Sensorelement
- 3.2: Zweites Sensorelement
- 3.3: Drittes Sensorelement
- 30: Auswerteeinheit
- 31, 32: Steuergerät
- 4: Funkschlüssel (Identifikationsmittel)
- 5: Schlüsseldetektor
- 51: Steuergerät
- 6: Rückleuchte
- 7: Hinweiseinrichtung
- 7.1, 7.2: Hinweiselement
- A1 - A6, A4*: Verfahrensschritte
- B: Ausgeleuchteter Hinweisbereich
- F: Fernbereich
- G: Türgriff
- H: Heckklappe
- K: Kraftfahrzeug
- L: Schlüsselloch
- N1, N2: Nahbereich
- O1, O2: Karosserieöffnung
- S: Schloss
- ST: Stoßfänger
- T: Seitentür

## Patentansprüche

1. Verfahren zur Steuerung einer Verstellbewegung eines fremdkraftbetätigt verstellbaren Fahrzeugschließelements, über das eine Karosserieöffnung eines Fahrzeugs verschließbar ist und das zum Freigeben der Karosserieöffnung bei Vorliegen eines Bedienereignisses automatisch verstellt werden kann, wobei das Verfahren folgende Schritte aufweist:
- Überwachen wenigstens eines Fernbereichs (F) in der Umgebung des Fahrzeugs (K) mittels mindestens eines ersten Sensorelements (3.1) des Fahrzeugs (K), wobei über das mindestens eine erste Sensorelement (3.1) berührungslos eine Person in dem Fernbereich (F) detektierbar ist,
- Durchführen eines Authentifizierungsprozesses, bei dem das Vorliegen eines gültigen Identifikationsmittels (4) in einem definierten Umgebungsbereich in der Umgebung des Fahrzeugs (K) überprüft wird, wenn über das mindestens eine erste Sensorelement (3.1) eine Person in dem Fernbereich (F) detektiert wurde,
- Überwachen wenigstens eines Nahbereichs (N2) in der Umgebung des Fahrzeugs (K) mittels mindestens eines zweiten Sensorelements (3.2, 3.3) des Fahrzeugs (K), das zu dem ersten Sensorelement (3.1) verschieden ist, wobei
∘ ein äußerster Rand des Nahbereichs (N2) näher an dem Fahrzeug (K) liegt als ein äußerster Rand des Fernbereichs (F),
∘ über das mindestens eine zweite Sensorelement (3.2, 3.3) berührungslos das Auftreten eines Bedienereignisses detektierbar ist, bei dem eine Person mit einem Körperteil eine bestimmte Bewegung in dem überwachten Nahbereich (N2) ausführt, und
∘ mindestens zwei räumlich voneinander getrennte Nahbereiche (N1, N2) überwacht werden, um eine als Bedienereignis zu bewertende Bewegung zu detektieren, wobei der mindestens eine weitere Nahbereich (N1) von dem ersten Sensorelement (3.1) überwacht wird, das auch den Fernbereich (F) überwacht,
und
- Verstellen des Fahrzeugsschließelements (T, H), wenn nacheinander eine Person in dem Fernbereich (F) detektiert, ein gültiges Identifikationsmittel (4) in dem Umgebungsbereich erkannt und ein Bedienereignis in dem wenigstens einen Nahbereich (N2) detektiert wurde.

2. Verfahren nach Anspruch 1, **dadurch gekennzeichnet, dass** das mindestens eine zweite Sensorelement (3.2, 3.3) zur Überwachung des Nahbereichs (N2) erst aktiviert wird, wenn über das mindestens eine erste Sensorelement (3.1) eine Person in dem Fernbereich (F) detektiert wurde und/oder ein gültiges Identifikationsmittel (4) in dem Umgebungsbereich erkannt wurde.

3. Verfahren nach einem der vorhergehenden Ansprüche, **dadurch gekennzeichnet, dass** bei der Überwachung des Fernbereichs (F) detektierbar ist, ob eine Person in den Fernbereich (F) eintritt.

4. Verfahren nach einem der vorhergehenden Ansprüche, **dadurch gekennzeichnet, dass** das mittels des mindestens einen ersten Sensorelements (3.1) detektiert wird, ob sich eine innerhalb des Fernbereichs (F) befindliche Person dem Fahrzeug (K) nähert.

5. Verfahren nach einem der vorhergehenden Ansprüche, **dadurch gekennzeichnet, dass** nach dem Detektieren einer Person in dem Fernbereich (F) oder nach der Erkennung eines gültigen Identifikationsmittels (4) in dem Umgebungsbereich mittels einer Hinweiseinrichtung (7) eine visuell und/oder akustisch wahrnehmbare Meldung an dem Fahrzeug (K) ausgegeben wird.

6. Verfahren nach Anspruch 5, **dadurch gekennzeichnet, dass** die Meldung durch ein beleuchtetes Hinweiselement (7.1) an dem Fahrzeug (K) und/oder ein zur Beleuchtung vorgesehenes Hinweiselement (7.2) an dem Fahrzeug (K) ausgegeben wird.

7. Verfahren nach Anspruch 6, **dadurch gekennzeichnet, dass** ein zur Beleuchtung vorgesehenes Hinweiselement (7.2) an dem Fahrzeug (K) wenigstens einen überwachten Nahbereich (N2) beleuchtet.

8. Verfahren nach Anspruch 6 oder 7, **dadurch gekennzeichnet, dass** ein Hinweiselement (7.1, 7.2) seine Helligkeit und/oder Lichtfarbe verändert, wenn ein Bedienereignis detektiert wurde.

9. Verfahren nach einem der Ansprüche 6 bis 8, **dadurch gekennzeichnet, dass** ein Hinweiselement (7.1, 7.2) blinkt, um eine visuell wahrnehmbare Meldung auszugeben und/oder das erfolgreiche Detektieren eines Bedienereignisses anzuzeigen.

10. Verfahren nach einem der vorhergehenden Ansprüche, **dadurch gekennzeichnet, dass** das Fahrzeugschließelement ein Seitentür (T) oder eine Heckklappe (H) ist und/oder das Identifikationsmittel ein Funkschlüsssel (4) des Fahrzeugs (K) ist.

11. Steuerungssystem für eine motorische Verstelleinrichtung zum Verstellen eines Fahrzeugschließelements, über das eine Karosserieöffnung eines Fahrzeugs verschließbar ist und das zum Freigeben der Karosserieöffnung bei Vorliegen eines Bedienereignisses automatisch verstellt werden kann, mit:
- mindestens einem ersten Sensorelement (3.1), das dazu eingerichtet und an dem Fahrzeug (K) vorgesehen ist, berührungslos wenigstens einen Fernbereich (F) in der Umgebung des Fahrzeugs (K) zu überwachen, so dass über das mindestens eine erste Sensorelement (3.1) berührungslos eine Person in dem Fernbereich (F) detektierbar ist,
- mindestens einer elektronischen Steuereinrichtung (1), die dazu eingerichtet und vorgesehen ist, einen Authentifizierungsprozess durchzuführen, bei dem das Vorliegen eines gültigen Identifikationsmittels (4) in einem definierten Umgebungsbereich in der Umgebung des Fahrzeugs (K) überprüft wird, wenn über das mindestens eine erste Sensorelement (3.1) eine Person in dem Fernbereich (F) detektiert wurde, und
- mindestens einem zweiten Sensorelement (3.2), das von zu dem ersten Sensorelement (3.1) verschieden ist und das dazu eingerichtet und an dem Fahrzeug (K) vorgesehen ist,
∘ berührungslos wenigstens einen Nahbereich (N2) in der Umgebung des Fahrzeugs (K) zu überwachen, der einen äußersten Rand aufweist, der näher an dem Fahrzeug (K) liegt als ein äußerster Rand des Fernbereichs (F), und
∘ berührungslos das Auftreten eines Bedienereignisses zu detektieren, bei dem eine Person mit einem Körperteil eine bestimmte Bewegung in dem überwachten Nahbereich (N2) ausführt,
wobei das mindestens eine erste Sensorelement (3.1), ferner dazu eingerichtet und an dem Fahrzeug (K) vorgesehen ist, auch einen weiteren Nahbereich (N1) zu überwachen, und
wobei die elektronische Steuereinrichtung (1) ferner dazu eingerichtet und vorgesehen, automatisch eine Verstellung des Fahrzeugsschließelements (T, H) zu veranlassen, wenn nacheinander eine Person in dem Fernbereich (F) detektiert, ein gültiges Identifikationsmittel (4) in dem Umgebungsbereich erkannt und eine als Bedienereignis zu bewertende Bewegung in den mindestens zwei räumlich voneinander getrennten Nahbereichen (N1, N2) detektiert wurde.

## Claims

1. A method for controlling an adjusting movement of a power-operated adjustable vehicle closing element, via which a body opening of a vehicle can be closed and which can automatically be adjusted for clearing the body opening in the presence of an operating event, the method including the following steps:
- monitoring at least one distant region (F) in the surroundings of the vehicle (K) by means of at least one first sensor element (3.1) of the vehicle (K), wherein via the at least one first sensor element (3.1) a person in the distant region (F) is detectable in a contactless manner,
- carrying out an authentification process in which the presence of a valid identification means (4) in a defined surrounding region in the surroundings of the vehicle (K) is checked when via the at least one first sensor element (3.1) a person has been detected in the distant region (F),
- monitoring at least one nearby region (N2) in the surroundings of the vehicle (K) by means of at least one second sensor element (3.2, 3.3) of the vehicle (K), which is different from the first sensor element (3.1), wherein
∘ an outermost edge of the nearby region (N2) is located closer to the vehicle (K) than an outermost edge of the distant region (F),
∘ via the at least one second sensor element (3.2, 3.3) the occurrence of an operating event is detectable in a contactless manner, in which a person performs a particular movement in the monitored nearby region (N2) with a body part, and
∘ at least two spatially separate nearby regions (N1, N2) are monitored, in order to detect a movement to be assessed as operating event, wherein the at least one further nearby region (N1) is monitored by the first sensor element (3.1) which also monitors the distant region (F),
and
- adjusting the vehicle closing element (T, H) when one after the other a person is detected in the distant region (F), a valid identification means (4) is detected in the surrounding region, and an operating event has been detected in the at least one nearby region (N2).

2. The method according to claim 1, **characterized in that** the at least one second sensor element (3.2, 3.3) for monitoring the nearby region (N2) only is activated when via the at least one first sensor element (3.1) a person has been detected in the distant region (F) and/or a valid identification means (4) has been detected in the surrounding region.

3. The method according to any of the preceding claims, **characterized in that** when monitoring the distant region (F) it can be detected whether a person enters into the distant region (F).

4. The method according to any of the preceding claims, **characterized in that** by means of the at least one first sensor element (3.1) it is detected whether a person present within the distant region (F) approaches the vehicle (K).

5. The method according to any of the preceding claims, **characterized in that** after detecting a person in the distant region (F) or after detecting a valid identification means (4) in the surrounding region, a visually and/or acoustically perceptible message is issued at the vehicle (K) by means of a signaling device (7).

6. The method according to claim 5, **characterized in that** the message is issued by an illuminated signaling element (7.1) at the vehicle (K) and/or a signaling element (7.2) provided for illumination at the vehicle (K).

7. The method according to claim 6, **characterized in that** a signaling element (7.2) provided at the vehicle (K) for illumination illuminates at least one monitored nearby region (N2).

8. The method according to claim 6 or 7, **characterized in that** a signaling element (7.1, 7.2) changes its brightness and/or light color when an operating event has been detected.

9. The method according to any of claims 6 to 8, **characterized in that** a signaling element (7.1, 7.2) flashes, in order to issue a visually perceptible message and/or indicate the successful detection of an operating event.

10. The method according to any of the preceding claims, **characterized in that** the vehicle closing element is a side door (T) or a liftgate (H) and/or the identification means is a radio key (4) of the vehicle (K).

11. A control system for a motorized adjusting device for adjusting a vehicle closing element, via which a body opening of a vehicle can be closed and which can automatically be adjusted for clearing the body opening in the presence of an operating event, comprising:
- at least one first sensor element (3.1) which is equipped and provided at the vehicle (K) for monitoring at least one distant region (F) in the surroundings of the vehicle (K) in a contactless manner, so that via the at least one first sensor element (3.1) a person in the distant region (F) is detectable in a contactless manner,
- at least one electronic control device (1) which is equipped and provided to carry out an authentification process in which the presence of a valid identification means (4) in a defined surrounding region in the surroundings of the vehicle (K) is checked when via the at least one first sensor element (3.1) a person has been detected in the distant region (F), and
- at least one second sensor element (3.2) which is different from the first sensor element (3.1) and which is equipped and provided at the vehicle (K),
∘ to monitor at least one nearby region (N2) in the surroundings of the vehicle (K) in a contactless manner, which includes an outermost edge which is located closer to the vehicle (K) than an outermost edge of the distant region (F), and
∘ to detect the occurrence of an operating event in a contactless manner, in which a person performs a particular movement in the monitored nearby region (N2) with a body part,
wherein the at least one first sensor element (3.1) furthermore is equipped and provided at the vehicle (K) for also monitoring a further nearby region (N1), and
wherein the electronic control device (1) furthermore is equipped and provided to automatically initiate an adjustment of the vehicle closing element (T, H) when one after the other a person is detected in the distant region (F), a valid identification means (4) is detected in the surrounding region, and a movement to be assessed as an operating event has been detected in the at least two spatially separate nearby regions (N1, N2).

## Revendications

1. Procédé de commande d'un mouvement de réglage d'un élément de fermeture de véhicule réglable par actionnement de force externe, par lequel une ouverture de carrosserie d'un véhicule peut être fermée et qui peut être réglé automatiquement pour la libération de l'ouverture de carrosserie en présence d'un événement d'utilisation, dans lequel le procédé présente les étapes suivantes :
- surveillance d'au moins une zone éloignée (F) dans l'environnement du véhicule (K) au moyen d'au moins un premier élément de capteur (3.1) du véhicule (K), dans lequel une personne dans la zone éloignée (F) peut être détectée sans contact par l'au moins un premier élément de capteur (3.1),
- réalisation d'un processus d'authentification par lequel la présence d'un moyen d'identification valide (4) est vérifiée dans une zone environnante définie dans l'environnement du véhicule (K), si une personne dans la zone éloignée (F) a été détectée par l'au moins un premier élément de capteur (3.1),
- surveillance d'au moins une zone proche (N2) dans l'environnement du véhicule (K) au moyen d'au moins un second élément de capteur (3.2, 3.3) du véhicule (K) qui est différent du premier élément de capteur (3.1), dans lequel
-- un bord extérieur de la zone proche (N2) se trouve plus près du véhicule (K) qu'un bord extérieur de la zone éloignée (F),
-- l'apparition d'un événement d'utilisation peut être détectée sans contact par l'au moins un second élément de capteur (3.2 3.3), par lequel une personne réalise avec une partie corporelle un mouvement déterminé dans la zone proche (N2) surveillée, et
-- au moins deux zones proches (N1, N2) séparées l'une de l'autre dans l'espace sont surveillées afin de détecter un mouvement à évaluer comme événement d'utilisation, dans lequel l'au moins une autre zone proche (N1) est surveillée par le premier élément de capteur (3.1) qui surveille aussi la zone éloignée (F),
et
- réglage de l'élément de fermeture de véhicule (T, H) si l'un après l'autre une personne a été détectée dans la zone éloignée (F), un moyen d'identification valide (4) a été reconnu dans la zone environnante et un événement d'utilisation a été détecté dans l'au moins une zone proche (N2).

2. Procédé selon la revendication 1, **caractérisé en ce que** l'au moins un second élément de capteur (3.2, 3.3) n'est activé que pour la surveillance de la zone proche (N2) si une personne a été détectée dans la zone éloignée (F) par l'au moins un premier élément de capteur (3.1) et/ou un moyen d'identification valide (4) a été reconnu dans la zone environnante.

3. Procédé selon l'une des revendications précédentes, **caractérisé en ce que** lors de la surveillance de la zone éloignée (F) il peut être détecté si une personne entre dans la zone éloignée (F).

4. Procédé selon l'une des revendications précédentes, **caractérisé en ce qu'**il est détecté au moyen de l'au moins un premier élément de capteur (3.1) si une personne se trouvant dans la zone éloignée (F) s'approche du véhicule (K).

5. Procédé selon l'une des revendications précédentes, **caractérisé en ce qu'**après la détection d'une personne dans la zone éloignée (F) ou après la reconnaissance d'un moyen d'identification valide (4) dans la zone environnante au moyen d'un dispositif d'indication (7) un message perceptible visuellement et/ou acoustiquement est émis au niveau du véhicule (K).

6. Procédé selon la revendication 5, **caractérisé en ce que** le message est émis par un élément d'indication (7.1) éclairé au niveau du véhicule (K) et/ou un élément d'indication (7.2) prévu pour l'éclairage est émis au niveau du véhicule (K).

7. Procédé selon la revendication 6, **caractérisé en ce qu'**un élément d'indication (7.2) prévu pour l'éclairage éclaire au niveau du véhicule (K) au moins une zone proche (N2) surveillée.

8. Procédé selon la revendication 6 ou 7, **caractérisé en ce qu'**un élément d'indication (7.1, 7.2) modifie sa luminosité et/ou sa couleur lumineuse si un événement d'utilisation a été détecté.

9. Procédé selon l'une des revendications 6 à 8, **caractérisé en ce qu'**un élément d'indication (7.1, 7.2) clignote afin d'émettre un message perceptible visuellement et/ou d'afficher la détection réussie d'un événement d'utilisation.

10. Procédé selon l'une des revendications précédentes, **caractérisé en ce que** l'élément de fermeture de véhicule est une porte latérale (T) ou un hayon arrière (H) et/ou le moyen d'identification est une clé à commande radio (4) du véhicule (K).

11. Système de commande pour un dispositif de réglage motorisé pour le réglage d'un élément de fermeture de véhicule par lequel une ouverture de carrosserie d'un véhicule peut être fermée et qui peut être réglé automatiquement pour la libération de l'ouverture de carrosserie en présence d'un événement d'utilisation, avec :
- au moins un premier élément de capteur (3.1) qui est aménagé et prévu sur le véhicule (K) afin de surveiller sans contact au moins une zone éloignée (F) dans l'environnement du véhicule (K) de sorte que par l'au moins un premier élément de capteur (3.1) une personne puisse être détectée sans contact dans la zone éloignée (F),
- au moins un dispositif de commande (1) électronique qui est aménagé et prévu afin de réaliser un processus d'authentification par lequel la présence d'un moyen d'identification (4) valide est vérifiée dans une zone environnante définie dans l'environnement du véhicule (K) si une personne a été détectée dans la zone éloignée (F) par l'au moins un premier élément de capteur (3.1), et
- au moins un second élément de capteur (3.2) qui est différent du premier élément de capteur (3.1) et qui est aménagé et prévu sur le véhicule (K) afin de
-- surveiller sans contact au moins une zone proche (N2) dans l'environnement du véhicule (K) qui présente un bord extérieur qui se trouve plus près du véhicule (K) qu'un bord extérieur de la zone éloignée (F), et
-- détecter sans contact l'apparition d'un événement d'utilisation pour lequel une personne réalise un mouvement déterminé avec une partie corporelle dans la zone proche (N2) surveillée,
dans lequel l'au moins un premier élément de capteur (3.1) est aménagé en outre et prévu sur le véhicule (K) afin de surveiller aussi une autre zone proche (N1), et
dans lequel le dispositif de commande électronique (1) est aménagé en outre et prévu afin de provoquer automatiquement un réglage de l'élément de fermeture de véhicule (T, H) si l'un après l'autre une personne a été détectée dans la zone éloignée (F), un moyen d'identification valide (4) a été reconnu dans la zone environnante et un mouvement à évaluer comme événement d'utilisation a été détecté dans les au moins deux zones proches (N1, N2) séparées l'une de l'autre dans l'espace.
